# EUROPEAN PATENT APPLICATION

(11) **EP 1 337 135 A2**
(43) Date of publication of application: **20.08.2003**
(21) Application number: 03250777.4
(22) Date of filing: 07.02.2003
(51) Int. Cl.: H05K 1/18

(54) **High frequency unit**

(30) Priority: 14.02.2002 JP 2002037081
(71) Applicant: Alps Electric Co., Ltd., Tokyo 145-8501 (JP)
(72) Inventor: Saito, Toshio,c/o Alps Electric Co., Ltd., Tokyo (JP)
(74) Representative: Kensett, John Hinton

(57) **Abstract**

In a high frequency unit according to the present invention, since outflow preventive means (11) for preventing an adhesive agent from flowing out is disposed on a circuit substrate (1) so as to surround the circumference of an IC component, an adhesive agent (6) is filled in a spacing between the IC component and the outflow preventive means, and the IC component is thus bonded to the circuit substrate by the adhesive agent, the outflow preventive means prevents the adhesive agent from flowing out towards solder, whereby the high frequency unit achieves high reliability and is also free from short circuiting between the solder and an adjacent land, occurrence of a solder ball, and short circuiting between adjacent conductive patterns.

## Description

### BACKGROUND OF THE INVENTION

### 1. Field of the Invention

The present invention relates to high frequency units suitable for use in an automobile electronic apparatus and the like.

### 2. Description of the Related Art

Regarding the accompanying drawings illustrating a known high frequency unit, Fig. 4 is a plan view of a major part of the known high frequency unit, Fig. 5 is a sectional view of the major part of the known high frequency unit, and Fig. 6 is a plan view of the major part of the known high frequency unit illustrating a state in which an adhesive agent has not yet been provided.

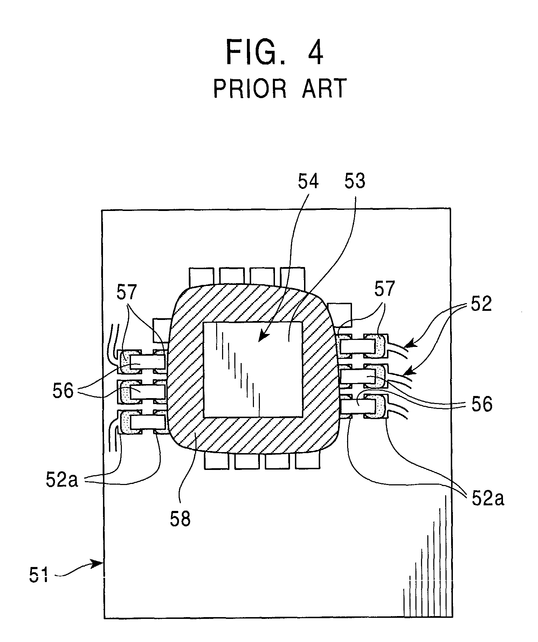

Referring now to Figs. 4 to 6, the known high frequency unit will be described. A circuit substrate 51 formed of a laminated substrate and so forth has conductive patterns 52 formed in and on the surface of the laminated substrate, and the conductive patterns 52 have a large number of lands 52a disposed at desired places thereof.

An IC component 54 having an outer package 53 composed of an insulating material is placed on the circuit substrate 51, and electrodes (not shown) disposed on the under surface of the IC component 54 are connected by soldering to the conductive patterns 52 via corresponding metal balls 55.

The lands 52a, some being independent from each other and the others connected to the IC component 54, are disposed around the IC component 54, whereby the density of the conductive patterns 52 is improved so as to achieve a reduced size.

Electrical components 56 such as a chip-type capacitor and resistor are bonded and wired by using solder 57 to the corresponding lands 52a disposed close to and away from the IC component 54.

Then, in such a state, a thermosetting adhesive agent 58 composed of an epoxy resin or the like is applied to the circumference of the IC component 54 so as to bond the IC component 54 to the circuit substrate 51, whereby the IC component 54 is prevented from becoming unstuck.

In this state, the uncured liquid adhesive agent 58 flows out close to the IC component 54, resulting in partially or entirely covering the solder 57 lying close to the IC component 54.

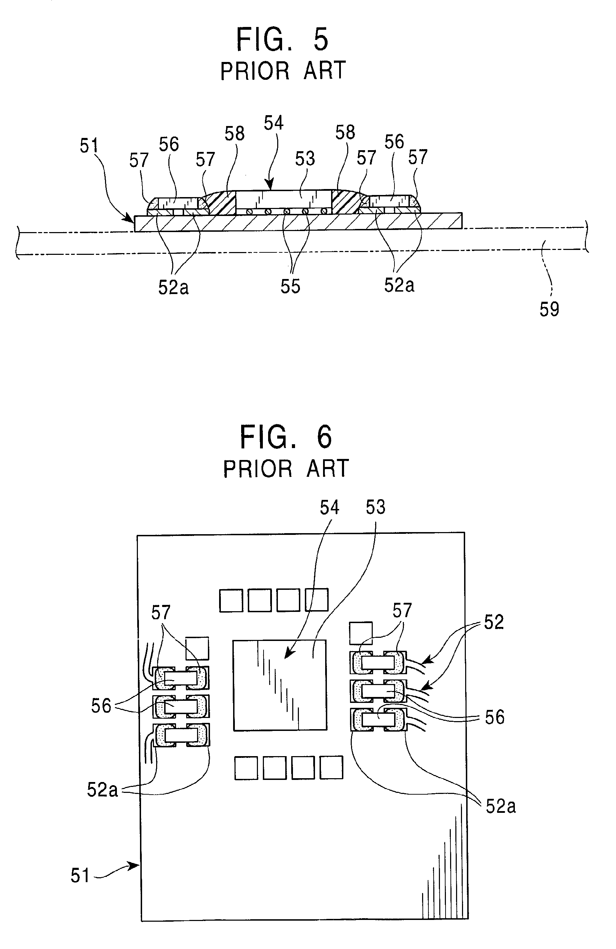

In the high frequency unit having the above-described structure, as shown in Fig. 5, the circuit substrate 51 is placed on a mother board 59 and is then incorporated into the mother board 59 by reflow-soldering.

In this reflow-soldering process, the solder 57 of the high frequency unit melts and expands.

Consequently, the expanded solder 57, which is partially covered by the adhesive agent 58, protrudes out from the adhesive agent 58 and extends to the adjacent land 52a, thereby causing a problem of short circuiting with the adjacent land 52a or the protruded solder 57 is separated from the corresponding lands 52a and becomes a solder ball, thereby causing a problem of accretion to the upper surface of the circuit substrate 51.

This solder ball is likely to accrete to the spacing between the adjacent conductive patterns 52 and thus to cause a problem of short circuiting therebetween, or is likely to move due to vibration of an electronic apparatus incorporating the high frequency unit and thus to cause a problem of short circuiting between the adjacent conductive lands 52.

Also, when the adhesive agent 58 contains pinholes, the expanded solder 57, which is entirely covered by the adhesive agent 58, flows out through the pinholes and becomes a solder ball, thereby causing a problem of accretion to the upper surface of the circuit substrate 51.

In the known high frequency unit having a structure in which the circumference of the IC component 54 and the solder 57 is covered by the adhesive agent 58, since the solder 57 melts and expands when the high frequency unit is mounted on the mother board 59, the solder 57 causes a problem of short circuiting with the adjacent land 52a, or produces a solder ball and thus causes a problem of short circuiting between the adjacent conductive patterns 52, thereby resulting in low reliability and defective products.

### SUMMARY OF THE INVENTION

Accordingly, it is an object of the present invention to provide a reliable high frequency unit which is free from defect.

According to the present invention, a high frequency unit comprises a circuit substrate including conductive patterns; an IC component placed on the circuit substrate; electrical components bonded by soldering to the conductive patterns disposed in the vicinity of the IC component; and outflow preventive means, for preventing an adhesive agent from flowing out, disposed on the circuit substrate so as to surround the circumference of the IC component, wherein the adhesive agent is filled in the spacing between the IC component and the outflow preventive means so as to bond the IC component to the circuit substrate.

With this structure, the outflow preventive means prevents the adhesive agent from flowing out towards the solder. Accordingly, its reliability is improved and the solder is prevented from causing a problem of short circuiting with corresponding adjacent land. In addition, since no solder ball is produced, short circuiting between the adjacent conductive patterns is prevented.

Preferably, the adhesive agent is composed of a thermosetting resin or a thermoplastic resin, whereby the IC component is reliably bonded to the circuit substrate.

The outflow preventive means may be a tube-like outflow preventive member formed by molding an insulating material, whereby the outflow preventive member can be made at low cost and also have a height in accordance with that of the IC component, and as a result, the adhesive agent is reliably prevented from flowing out.

Space holders may be disposed on at least one of the outflow preventive member and the IC component so as to maintain the spacing between the IC component and the outflow preventive member, whereby the spacing between the outflow preventive member and IC component is reliably maintained, and as a result, the IC component is reliably bonded to the circuit substrate.

The outflow preventive member may be engaged with and held to the IC component by having the space holders interposed therebetween, whereby the outflow preventive member is temporally fixed to the IC component, resulting in an easy operation of filling the adhesive agent and accordingly in good workability.

### BRIEF DESCRIPTION OF THE DRAWINGS

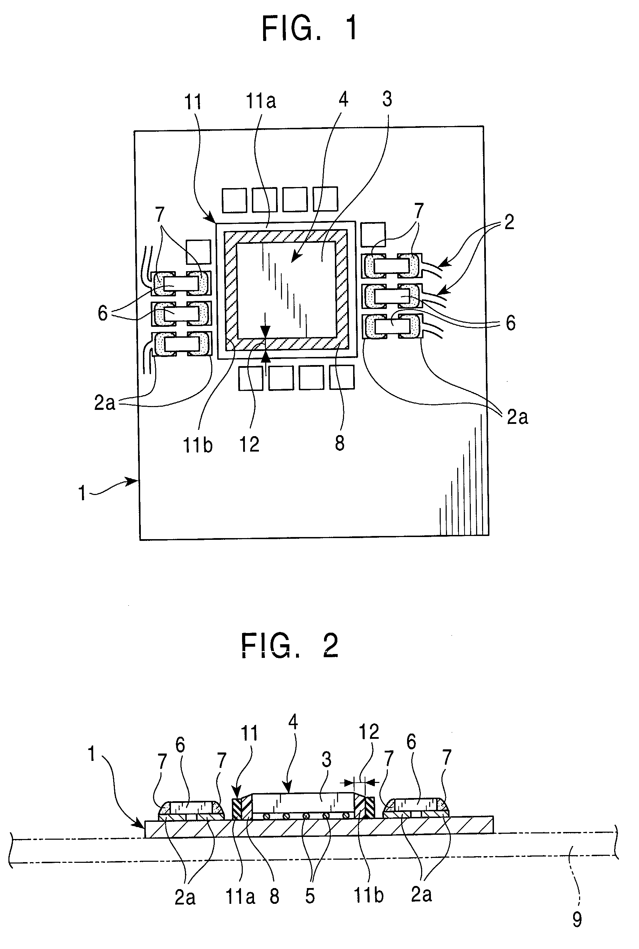

Fig. 1 is a plan view of a major part of a high frequency unit according to a first embodiment of the present invention;
Fig. 2 is a sectional view of the major part of the high frequency unit according to the first embodiment of the present invention;

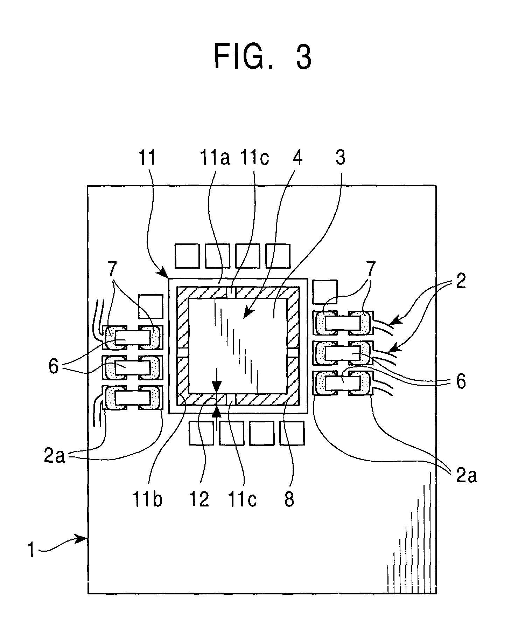

Fig. 3 is a plan view of a major part of a high frequency unit according to a second embodiment of the present invention;
Fig. 4 is a plan view of a major part of a known high frequency unit;
Fig. 5 is a sectional view of the major part of the known high frequency unit; and
Fig. 6 is a plan view of the major part of the known high frequency unit illustrating a state in which an adhesive agent has not yet been provided.

### DESCRIPTION OF THE PREFERRED EMBODIMENTS

Regarding the accompanying drawings illustrating high frequency units according to the present invention, Fig. 1 is a plan view of a major part of a high frequency unit according to a first embodiment of the present invention, Fig. 2 is a sectional view of the major part of the high frequency unit according to the first embodiment of the present invention, and Fig. 3 is a plan view of a major part of a high frequency unit according to a second embodiment of the present invention.

Referring now to Figs. 1 and 2, the structure of the high frequency unit according to the first embodiment of the present invention will be described. A circuit substrate 1 formed of a laminated substrate and so forth has conductive patterns 2 formed in and on the surface of the laminated substrate, and the conductive patterns 2 have a large number of lands 2a disposed at desired places thereof.

An IC component 4 including an outer package 3 composed of an insulating material is placed on the circuit substrate 1, and electrodes (not shown) disposed on the under surface of the IC component 4 are connected by soldering to the conductive patterns 2 via corresponding metal balls 5.

The lands 2a, some being independent from each other and the others connected to the IC component 4, are disposed around the IC component 4 so as to improve the density of the conductive patterns 2 and thus to achieve a reduced size.

Electrical components 6 such as a chip-type capacitor and resistor are bonded and wired by using solder 7 to the corresponding lands 2a disposed close to and away from the IC component 4.

A square-tube-shaped outflow preventive member 11 formed by molding an insulating material and serving as outflow preventive means has a wall 11a and a hollow 11b provided inside the wall 11a.

The outflow preventive member 11 is fixed on the circuit substrate 1 by appropriate means in a state in which the IC component 4 is placed in the hollow 11b so as to provide a clearance 12 between the wall 11a and the IC component 4.

As a result, the circumference of the IC component 4 is entirely surrounded by the wall 11a.

In such a state, a thermosetting adhesive agent 8 composed of an epoxy resin or the like is filled in the clearance 12 provided between the circumference of the IC component 4 and the wall 11a so as to bond the IC component 4 to the circuit substrate 1, whereby the IC component 4 is prevented from becoming unstuck.

Also, in this state, since the outflow preventive member 11 prevents the adhesive agent 8 from flowing out towards the solder 7, the solder 7 is not covered by the adhesive agent 8.

In the high frequency unit having the above-described structure, as shown in Fig. 2, the circuit substrate 1 is placed on a mother board 9 and is then incorporated into the mother board 9 by reflow-soldering.

In this reflow-soldering process, the solder 7 of the high frequency unit melts and expands; however, the solder 7 is not covered by the adhesive agent 8, whereby the expanded solder does not cause a problem of protruding out from the adhesive agent.

Accordingly, the solder 7 does not cause a problem of short circuiting with the adjacent land 2a, and no short circuiting between the adjacent conductive patterns 2 occurs since no solder ball is produced.

Although the tube-shaped outflow preventive member 11 is used as the outflow preventive means for preventing the adhesive agent from flowing out in this embodiment, this outflow preventive means may be formed such that a solder resist layer or a silk layer is laminated on the circuit substrate so as to surround the circumference of the IC component.

Also, the adhesive agent is composed of a thermosetting resin in this embodiment; alternatively it may be composed of a thermoplastic resin.

Referring now to Fig. 3, the structure of the high frequency unit according to the second embodiment of the present invention will be described. The outflow preventive member 11 has a plurality of space holders 11c, which protrude into the hollow 11b, formed on the wall 11a, and the space holders 11c abut against the IC component 4 so that the spacing between the wall 11a and the IC component 4 is kept so as to maintain the clearance 12, and also the space holders 11c are engaged with and held to the IC component 4 by sandwiching and holding the IC component from the four sides thereof) so that the outflow preventive member 11 is temporally fixed to the IC component 4.

Since the remaining structure is the same as that in the first embodiment, like parts are denoted by the same reference numbers and the description thereof will be omitted.

Although the space holders are disposed on the outflow preventive member in this embodiment, the space holders may be disposed on the IC component or on both the IC component and the outflow preventive member.

## Claims

1. A high frequency unit comprising: a circuit substrate including conductive patterns; an IC component placed on the circuit substrate; electrical components bonded by soldering to the conductive patterns disposed in the vicinity of the IC component; and outflow preventive means, for preventing an adhesive agent from flowing out, disposed on the circuit substrate so as to surround the circumference of the IC component, wherein the adhesive agent is filled in the spacing between the IC component and the outflow preventive means so as to bond the IC component to the circuit substrate.

2. The high frequency unit according to Claim 1, wherein the adhesive agent comprises a thermosetting resin or a thermoplastic resin.

3. The high frequency unit according to Claim 1 or 2, wherein the outflow preventive means is a tube-like outflow preventive member formed by molding an insulating material.

4. The high frequency unit according to Claim 1, 2 or 3, wherein space holders are disposed on at least one of the outflow preventive member and the IC component so as to maintain the spacing between the IC component and the outflow preventive member.

5. The high frequency unit according to Claim 4, wherein the outflow preventive member is engaged with and held to the IC component by disposing the space holders.
